# EUROPEAN PATENT SPECIFICATION

(11) **EP 0 605 929 B1**
(45) Date of publication and mention of the grant of the patent: **29.07.1998**
(21) Application number: 93203700.5
(22) Date of filing: 27.12.1993
(51) Int. Cl.: G11B 7/125, G11B 7/135, G02B 5/18, H01S 3/133, G02B 26/10

(54) **Device for optically scanning a surface**
Vorrichtung zur optischen Abtastung einer Fläche
Dispositif pour balayer optiquement une surface

(30) Priority: 04.01.1993 EP 93200002
(43) Date of publication of application: 13.07.1994
(73) Proprietor: Philips Electronics N.V., 5621 BA Eindhoven (NL)
(72) Inventor: Ophey, Willem Gerard, NL-5656 AA Eindhoven (NL)
(74) Representative: Faessen, Louis Marie Hubertus

(56) References cited:
- EP-A- 0 372 629
- EP-A- 0 452 793
- EP-A- 0 495 413
- US-A- 4 358 200
- US-A- 4 665 310
- US-A- 5 212 572
- US-A- 5 233 595
- PATENT ABSTRACTS OF JAPAN vol. 13, no. 353 (P-913) 8 August 1989 & JP-A-01 112 534
- PATENT ABSTRACTS OF JAPAN vol. 17, no. 132 (P-1504) 18 March 1993 & JP-A-04 311 828
- PATENT ABSTRACTS OF JAPAN vol. 13, no. 572 (P-978) 18 December 1989 & JP-A-01 241 030
- PATENT ABSTRACTS OF JAPAN vol. 14, no. 561 (P-1142) 13 December 1990 & JP-A-02 239 434

## Description

The invention relates to a device for emitting radiation on to a surface, comprising a radiation source for supplying a radiation beam, a grating having a first grating structure for forming at least a deflected sub-beam from the radiation beam supplied by the radiation source or from a beam reflected by the surface, a radiation-sensitive detection system for converting radiation reflected by the surface into electric signals, means for forming a monitor beam from the beam supplied by the radiation source, and a monitor detector for converting the monitor beam into an electric signal for controlling the radiation source.

A device of the type described in the opening paragraph is known from European Patent Application no. 0 372 629 (PHN 12.753). This device can be used for scanning a record carrier by means of a radiation beam. A three-spot grating is placed in the radiation beam of the device. In transmission, this grating forms two first-order diffracted sub-beams from the radiation beam. Together with the on-going non-deflected main beam, the two sub-beams are focused by an objective system to three spots on the record carrier. The main spot formed by the main beam is used for writing or reading information in the tracks of the record carrier. The side spots formed by the side beams are used for generating a tracking signal with which a circuit is controlled which keeps the main spot on the track to be scanned.

When information is being written in the record carrier, it is desirable that the power in the main beam is maintained accurately at a given value, referred to as the write power. To this end a reflector is arranged around the grating, which reflector reflects a part of the radiation from the radiation source falling outside the grating, referred to as the border radiation, to a monitor detector arranged beside the radiation source. The signal from the monitor detector is subsequently used for controlling the power supplied by the radiation source. A drawback is that the ratio between the border radiation power and the main beam power is dependent on the radiation source used, so that the monitor detector must be calibrated for each device.

It is an object of the present invention to provide a device for optically scanning a surface which does not have the above-mentioned drawback. To this end the device according to the invention is characterized in that the monitor beam-forming means are constituted by a second grating structure in the grating and in that the monitor beam consists of radiation reflected by the grating. The monitor beam is formed from the same part of the radiation beam as the part from which the grating forms the main beam. Consequently, the power in the monitor beam is a fixed fraction of the power in the main beam. The output signal of the monitor detector is then a direct measure of the power in the main beam so that it is no longer necessary to calibrate. By giving the two grating structures a given, mutual orientation, the direction of this beam can be made approximately equal to the direction of the main beam to be captured by the radiation-sensitive detection system. This provides the possibility of integrating the monitor detector with the detection system so that the device can be made in a simpler manner and at lower cost.

It is to be noted that it is known from Japanese Patent Application JP-A 3-83885 to provide a grating in the housing of a diode laser, which grating reflects a part of the radiation from the radiation source to a monitor detector. This publication does not state that this unit of radiation source and monitor diode can be used in a scanning device and that the grating can be integrated with another grating and the monitor diode can be integrated with other signal photodiodes.

An embodiment of the device according to the invention is characterized in that the first grating structure has a grating groove depth which is approximately equal to half the wavelength of the radiation and in that the second grating structure is blazed for preferential diffraction in the direction of the monitor detector. By choosing half a wavelength for the depth of the first grating structure, measured at the air side of the grating, it is achieved that this grating structure reflects little radiation from the source in diffraction beams, which thus yields a high transmission for the radiation towards the surface to be scanned. The invention is based on the recognition that the reflection of the second grating structure is still sufficiently large to obtain sufficient radiation on the monitor diode, provided that it is ensured, by means of an operation referred to as "blazing" of the second grating structure, that this radiation is concentrated as much as possible into a beam of one diffraction order.

The modified grating also forms beams which are diffracted by the two grating structures in a first or a higher order. Such beams only cause loss of radiation. This radiation is reduced in a device according to the invention which is characterized in that the grating grooves of the first grating structure are substantially perpendicular to the grating grooves of the second grating structure. The deviation from perpendicular is preferably smaller than 30°. The combination of this measure with said choice of the depth of the grating grooves and blazing of the first and second grating structures results in an even more effective suppression of these beams.

A particular embodiment of the device according to the invention is characterized in that the second grating structure has optical power. Due to the optical power, the monitor beam is focused on the monitor detector so that the monitor detector may be small.

An embodiment of the device according to the invention is characterized in that the first grating structure is a linear grating structure for forming a non-deflected main beam and two side beams deflected in opposite directions from the radiation beam supplied by the source, and in that the detection system has a separate detector for each of the three beams reflected by the surface. The first grating structure generates, in transmission, the two sub-beams which, in the form of two side beams at both sides of the main beam, are formed by the objective system to two side spots at both sides of the main spot. The radiation reflected by these side spots is detected by means of the detection system in order to derive a signal indicating the extent to which the main spot correctly tracks the track to be scanned.

An embodiment of the device according to the invention is characterized in that the first grating structure is adapted to deflect a radiation beam reflected by the surface towards the detection system and to deform the deflected beam in such a way that a focus error signal can be derived therefrom by means of the detection system. A special grating structure can introduce astigmatism into the deflected beam so that a focus error signal in accordance with the astigmatic method can be generated with this beam. Two sub-beams, from which a focus error signal can also be generated by means of the Foucault method, can be generated with a different grating structure. These and other aspects of the invention will be apparent from and elucidated with reference to the embodiments described hereinafter.

In the drawings
Fig. 1 shows a first embodiment of the device according to the invention;
Fig. 2 shows a second embodiment of the device according to the invention;
Fig. 3 is a bottom view of the grating as used in the device of Fig. 2;
Fig. 4 is a side elevation of a detail of the grating;
Fig. 5 shows a radiation source-detection unit.

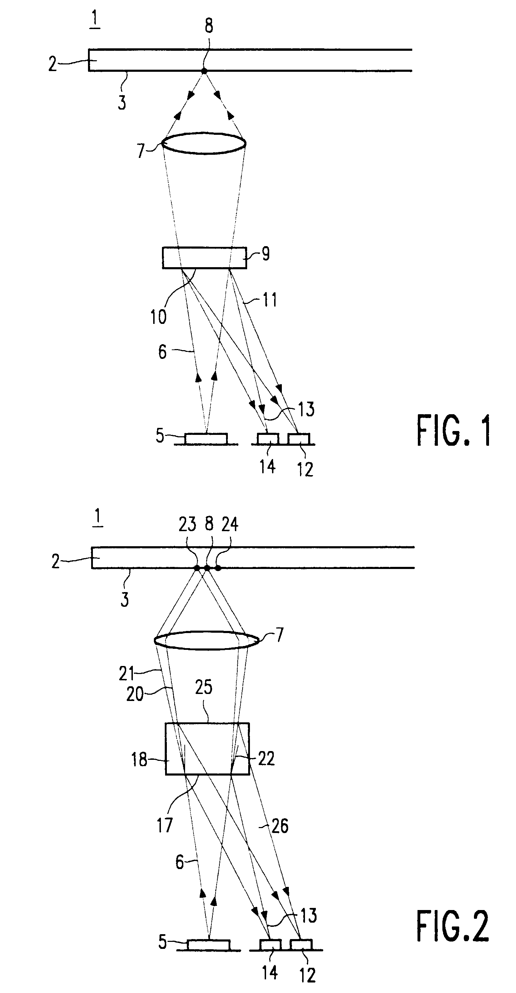

Fig. 1 shows a device for scanning an optical record carrier 1, a part of which is shown in a cross-section. The record carrier comprises a substrate 2 provided with a reflecting recording layer 3. In the configuration shown the recording layer is scanned from the air side; it is, however, preferred to scan the recording layer through the then transparent substrate. The information on the recording layer is ordered in tracks which are not shown in the Figure. A radiation source 5, for example a semiconductor laser, supplies a radiation beam 6 which is focused by an objective system 7 on the recording layer 3 to form a spot 8 for scanning the recording layer. It must be possible to detect the beam reflected by the recording layer and modulated by the information structure, for which purpose this beam must be separated from the on-going beam. To this end the device can be provided in known manner with a transparent plate 9 provided with a grating 10 which is dimensioned in such a way that it passes the reflected beam substantially in a given diffraction order. The sub-beam thus formed and deflected is captured by a detection system 12 which converts the sub-beam into one or more electric signals, for example an information signal, a tracking error signal and a focus error signal. The tracking error signal and the focus error signal are used in servocircuits (not shown) for controlling the position of the spot 8 in such a way that it remains in the recording plane and continues to track the track to be scanned.

The grating 10 may have a first grating structure with straight grating grooves. Due to a special curvature of the grating grooves, *inter alia* known from United States Patent no. 4,358,200, the deflected sub-beam 11 can be made astigmatic. If the detection system 12 has four detectors arranged in quadrants, onto whose centre the sub-beam is directed, a focus error signal can be derived from the output signals of the four detectors in accordance with the astigmatic method as described in said United States Patent. In another embodiment, known from United States Patent no. 4,665,310, the grating 10 has two sub-gratings at both sides of a dividing line, in which each sub-grating has a series of substantially parallel grating grooves, while the grating grooves of the first sub-grating extend at a first angle and those of the second sub-grating extend at a second, for example equally large but opposite angle to the dividing line. The two sub-gratings of such a Foucault grating each form a sub-beam from the radiation reflected by the recording plane. These sub-beams, which have different directions, are incident on separate detector pairs of the detection system. The output signals of these detectors are processed to a focus error signal. This detection method is known as the Foucault method.

For measuring the power in the spot 8 on the recording layer 3, the structure of the grating 10 is modified in accordance with the invention in such a way that the part of the on-going radiation beam 6 reflected by the grating is deflected into a diffracted monitor beam 13. A monitor detector 14 converts this beam into a control signal which is used for maintaining the power supplied by the radiation source at a desired value. The new grating is composed of a first grating structure for deflecting and possibly diffracting the signal and servobeam 11 into a shape suitable for focus detection, on which first grating structure a second grating structure for forming the monitor beam 13 is superimposed. The grating grooves of the second grating structure may be curved to give the structure an optical power. Due to this power a converging monitor beam 13 is formed from the diverging radiation beam 6. The average angle between the grating grooves of the first and second grating structures is preferably approximately 90° in order to reduce the interference between the two grating structures and to enhance the possibility of manufacturing the grating. In that case the monitor detector 14 is arranged in front of or behind the radiation source 5, viewed in a direction perpendicular to the plane of the drawing in Fig. 1.

Fig. 2 shows another embodiment of the device according to the invention. The radiation beam 6 from the radiation source 5 is split into a non-deflected main beam 20 and two deflected side beams 21, 22 by a grating 17 arranged on a transparent plate 18. For the sake of clarity, only one of the side beams 21 is shown completely in the Figure. The grating 17 has a first grating structure, which is known as a three-spot grating, having substantially equidistant, straight grating grooves. The objective system 7 focuses the main beam 20 and side beams 21, 22 formed by this grating structure to a main spot 8 and two side spots 23, 24, respectively, on the recording layer 3. A second grating 25 deflecting a substantial part of the radiation reflected by the recording layer as beam 26 to a signal and servodetection system 12 is arranged on the plate 18. This second grating 25 may have approximately the same grating structure as the first grating structure in the grating 10 of Fig. 1. An information signal as well as a focus error signal can be derived in accordance with either the astigmatic or the Foucault method from the signals supplied by the detection system 12. Fig. 2 only shows the deflected reflected main beam 26. The grating 25 also deflects the reflected side beams 21 and 22 towards the detection system. This system comprises two extra detectors for converting the reflected and deflected side beam radiation into electric signals from which a tracking error signal can be derived. For further information about reading information and about the systems for tracking and/or focusing, reference is made to said European Patent Application EP 0 372 629.

According to the invention, the grating 17 in the device shown in Fig. 2 is modified in such a way that the reflected part of the radiation beam is deflected into a monitor beam 13. The power in the monitor beam is proportional to the power generated by the radiation source. The monitor beam is incident on a monitor detector 14 which converts the incident radiation into an electric signal for controlling the radiation power of the radiation source 5. The modification of the grating consists of combining the first grating structure with a second grating structure. The second grating structure comprises a collection of grating grooves which may be curved. The curvature gives the grating structure an optical power so that the monitor beam 13 is a converging beam. The grating grooves of the first grating structure preferably extend in a direction which is perpendicular to the average direction of the grating grooves of the second grating structure. In contrast to what is shown in Fig. 2, the side beams 21, 22 are then substantially deflected in a direction perpendicular to the plane of the drawing. The distances between the side spots 23, 24 and the main spot 8 on the recording layer 3 will therefore be larger in the direction perpendicular to the plane of the drawing than the distances between the side spots and the main spot in the plane of the drawing. The positions of the monitor detector 14 and the part of the detection system 12 intended for the beam 26 remain unchanged so that these elements can be advantageously integrated, as is also the case for these elements in Fig. 1.

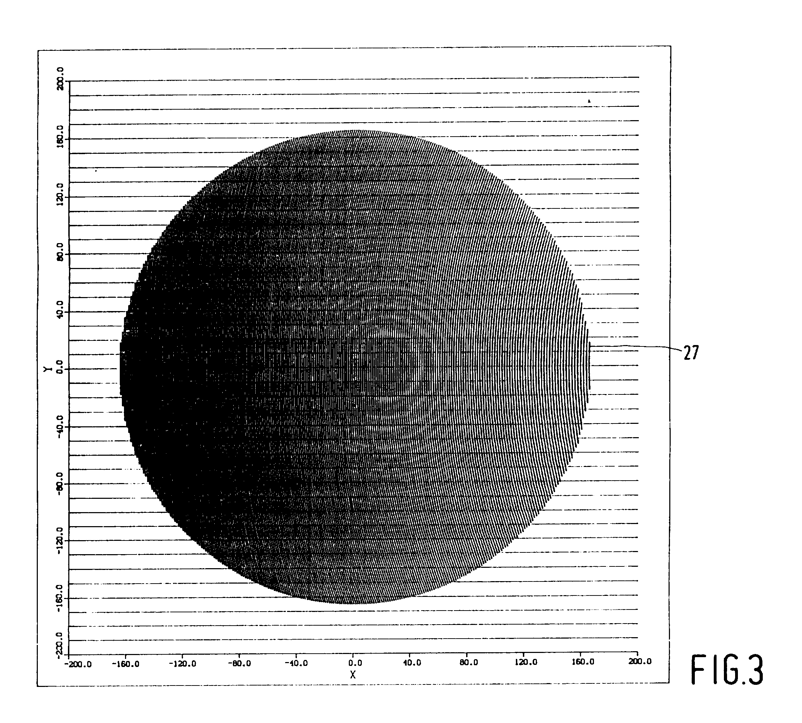

Fig. 3 is an elevational view of an embodiment of the grating 17, viewed from the side of the radiation source 5. The numbers along the axes X, Y in the Figure indicate distances in micrometers. The horizontal lines in the Figure represent the first grating structure having a period of, for example 10 µm. Each period consists of a groove having a rectangular cross-section and a width of 5 µm and an intermediate strip having a width of 5 µm as well. The substantially vertical lines in the Figure represent the second grating structure whose period across the grating diameter varies from, for example 1 µm to, for example 2 µm. The second grating structure has, for example a sawtooth-shaped profile. The objective system 7 has such a position and dimensions that the radiation of the radiation source 5 falling within the circular boundary 27 of the second grating structure and being passed is also passed by the objective system and focused to the spots 8, 23, 24 on the recording layer 3. For the sake of clarity, the horizontal lines of the first grating structure extend beyond the boundary 27. Since the monitor beam originates from the grating area within the boundary 27, the monitor beam comprises a fraction of that part of the radiation beam 6 which is used for forming the spots. Consequently, the part of the radiation beam 6 falling outside the boundary 27 is not measured. The power measured by the monitor detector 14 is thus a good measure of the power in the spots.

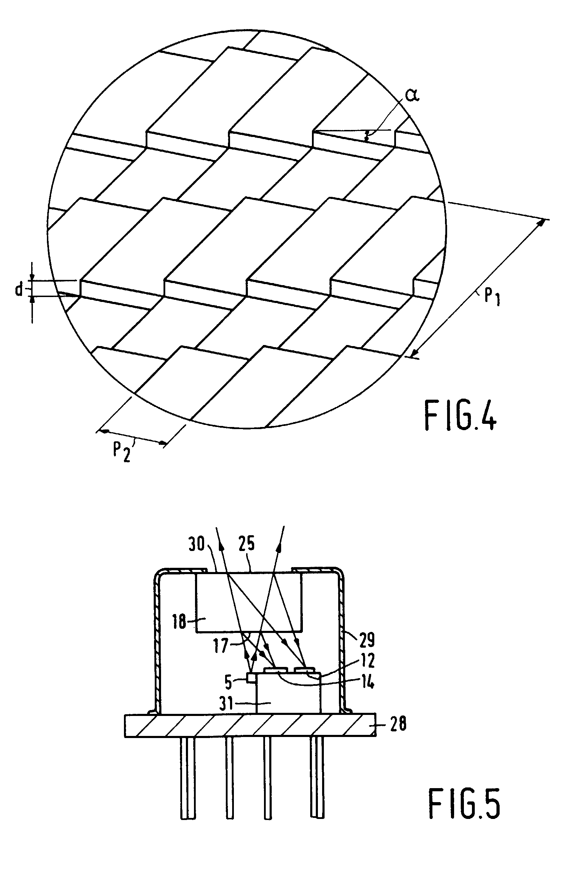

Fig. 4 is an oblique elevational view of a magnification of a part of the grating 17 in which the first and second grating structures can be clearly distinguished. In the grating embodiment shown, the depth of the grooves of the first grating structure is equal to that of the second grating structure. The period of the first grating structure is denoted by p₁, and the period of the second grating structure is denoted by p₂. Dependent on the wavelength and the direction of the incident radiation, the period of a grating structure determines the direction of the deflected radiation. If this grating is arranged in the device of Fig. 2, the reflected part of the radiation beam 6 will be diffracted in a first order towards the monitor detector 14 due to the chosen period of the second grating structure. The radiation reflected by the recording layer 3 is diffracted in transmission by the second grating structure. Since, in transmission, there is a refractive index transition from the material of the plate 18 to air, the angle at which the diffracted beam exits from the grating 17 will be different than the angle at which the monitor beam 13 leaves the grating. Consequently, the radiation reflected by the record carrier does not generate any focused beams which are located very close to the monitor beam 13, which might detrimentally influence the measurement of the power in the monitor beam by the monitor detector 14.

In an embodiment of the device shown in Fig. 2, in which the plate 18 is provided at one side with the grating 17 and at the other side with a grating 25 in the form of a Foucault grating, the detection system 12 has two detector pairs which are arranged at some distance from each other in a direction perpendicular to the plane of the drawing. In the case of a given positioning of the gratings 17 and 25 with respect to each other, the diffraction beams of the grating 17 will form radiation spots between said two detector pairs in the direction of the monitor detector 14. Diffraction beams, which may be present beside the monitor beam 13, will thus not influence the detection of one or more sub-beams 11 by the detection system 12.

The depth of the grating grooves of the first grating structure in Fig. 4 is denoted by d. If this depth, measured in air, is approximately equal to half the wavelength of the radiation, combined with an approximately equal width of the grooves and the intermediate strips, only little radiation from the source 5 will be reflected by the first grating structure in diffraction beams. Since the second grating structure preferably diffracts the incident radiation in the monitor beam 13, the radiation diffracted in reflection by the grating 17 will largely be deflected in the monitor beam 13 towards the monitor detector 14. The angle between the long side of the sawtooth profile of the second grating structure and the plane of the grating is denoted by α in Fig. 4. The angle α is also referred to as blaze angle. By suitable choice of the blaze angle, the power of the monitor beam 13 diffracted in a given order may be increased at the expense of the other beams (not shown) which are diffracted in different orders by the second grating structure. Preferably, there is a small variation of the blaze angle across the diameter of the second grating structure so as to obtain a satisfactory focusing of the monitor beam 13 on the monitor detector 14. The power of the side beams 21 and 22 with respect to the main beam 20 can be determined by means of the groove depth and the ratio between the width of these grooves and the intermediate strips of the first grating structure.

The plate 18 with the gratings, the radiation source 5, the detection system 12 and the monitor detector 14 can be integrated in one radiation source-detection unit, as is shown in Fig. 5. The unit has a base plate 28 through which electric connections have been made. A cylindrical housing 29 having an aperture 30 at its upper side is mounted on the base plate. The inner side of the transparent plate 18 is secured to the aperture. The radiation source 5 in the form of a semiconductor laser is mounted on a block 31. The monitor detector 14 and the detection system 12 are also mounted on the block. A possible difference in height between the radiation source and the radiation-sensitive surface of the detectors can be compensated for by giving the second grating structure in the grating 17 and the second grating 25 a slightly different optical power. Some measures of a given embodiment of the radiation source-detection unit are: thickness of the plate 18:3 mm; distance between the radiation source 5 and the plate: 1.5 mm; distance between the radiation source and the centre of the monitor detector 14: 1 mm; distance between the radiation source and the centre of the detection system 12: 1.5 mm.

In a possible method of manufacture of the grating 10 or 17, the fine, blazed second grating structure is first provided in the plate 9 or 18 by means of the following steps: providing a lacquer layer on the plate, exposing the lacquer layer with a pattern in accordance with the second grating structure, developing the lacquer layer to the desired depth and converting the exposure pattern into a profile in the material of the plate by means of reactive ion etching. After removal of the lacquer residues, the coarser, first grating structure is provided by means of the following steps: providing a lacquer layer on the plate at the area of the second grating structure, exposing the lacquer layer with a pattern in accordance with the first grating structure, developing the lacquer layer, lowering the parts of the second grating structure corresponding to the grooves of the first grating structure to the desired depth by means of reactive ion etching, and removing the lacquer residues.

The invention may be used advantageously in all types of devices for writing, reading and/or erasing in optical record carriers in which the information is recorded in the form of, for example pits, of areas having a different reflection coefficient than their surroundings, such as those which are formed in phase-change materials, or of magnetic domains. The described grating 17 having the two grating structures may be further used in all devices for scanning surfaces by means of a radiation beam. Such a surface need not be a recording surface in an optical record carrier, but it may be any arbitrary surface to be examined.

## Claims

1. A device for emitting radiation onto a surface (3), comprising a radiation source (5) for supplying a radiation beam (6), a grating (17) having a first grating structure for forming at least a deflected sub-beam (21) from the radiation beam supplied by the radiation source or from a beam reflected by the surface, a radiation-sensitive detection system (12) for converting radiation reflected by the surface into electric signals, means (17) for forming a monitor beam (13) from the beam (6) supplied by the radiation source, and a monitor detector (14) for converting the monitor beam into an electric signal for controlling the radiation source, characterized in that the monitor beam-forming means (17) are constituted by a second grating structure in the grating (17) and in that the monitor beam consists of radiation reflected by the grating.

2. A device as claimed in Claim 1, characterized in that the first grating structure has a grating groove depth which is approximately equal to half the wavelength of the radiation and in that the second grating structure is blazed for preferential diffraction in the direction of the monitor detector.

3. A device as claimed in Claim 2, characterized in that the grating grooves of the first grating structure are substantially perpendicular to the grating grooves of the second grating structure.

4. A device as claimed in Claim 2 or 3, characterized in that the second grating structure has optical power.

5. A device as claimed in Claim 1, 2, 3 or 4, characterized in that the first grating structure is a linear grating structure for forming a non-deflected main beam and two side beams deflected in opposite directions from the radiation beam supplied by the source, and in that the detection system has a separate detector for each of the three beams reflected by the surface.

6. A device as claimed in Claim 1, 2, 3 or 4, characterized in that the first grating structure is adapted to deflect a radiation beam reflected by the surface towards the detection system and to deform the deflected beam in such a way that a focus error signal can be derived therefrom by means of the detection system.

7. A device as claimed in any one of the preceding Claims, characterized in that the device comprises focusing means (7) for focusing radiation supplied by the radiation source-detection unit to a spot (8) on the surface (3) and scanning means for controlling the position of the spot.

## Patentansprüche

1. Vorrichtung zum Aussenden von Strahlung auf eine Oberfläche (3), mit einer Strahlungsquelle (5) zum Aussenden eines Strahlungsbündels (6), mit einem Gitter (17) mit einer ersten Gitterstruktur zum Erzeugen wenigstens eines abgelenkten Teilbündels (21) aus dem von der Strahlungsquelle erzeugten oder von einem von der Oberfläche reflektierten Bündel erzeugten Strahlungsbündel, mit einem strahlungsempfindlichen Detektorsystem (12) zum Umsetzen der von der Oberfläche reflektierten Strahlung in elektrische Signale, mit Mitteln (17) zur Erzeugung eines Monitorbündels (13) aus dem von der Strahlungsquelle gelieferten Bündel (6), und mit einem Monitordetektor (14) zum Umsetzen des Monitorbündels in ein elektrisches Signal zur Steuerung der Strahlungsquelle, dadurch gekennzeichnet, dass die Monitorbündel erzeugende Mittel (17) aus einer zweiten Gitterstruktur im Gitter (17) besteht, und das Monitorbündel aus von dem Gitter reflektierter Strahlung besteht.

2. Vorrichtung nach Anspruch 1, dadurch gekennzeichnet, dass die erste Gitterstruktur eine Gitterrillentiefe hat, die etwa gleich der Hälfte der Wellenlänge der Strahlung ist, und dass die zweite Gitterstruktur für bevorzugte Beugung in der Richtung des Monitordetektors blazed ist.

3. Vorrichtung nach Anspruch 2, dadurch gekennzeichnet, dass die Gitterrillen der ersten Gitterstruktur im Wesentlichen senkrecht zu den Gitterrillen der zweiten Gitterstruktur verlaufen.

4. Vorrichtung nach Anspruch 2 oder 3, dadurch gekennzeichnet, dass die zweite Gitterstruktur optische Energie hat.

5. Vorrichtung nach Anspruch 1, 2, 3 oder 4, dadurch gekennzeichnet, dass die erste Gitterstruktur eine lineare Gitterstruktur zum Erzeugen eines nichtabgelenkten Hauptstrahls und von zwei Seitenbündeln ist, die in entgegengesetzen Richtungen vom Strahlungsbündel abgelenkt werden, dass von der Quelle ausgesandt wird, und dass das Detektorsystem einen getrennten Detektor für jedes der drei von der Oberfläche reflektierten Bündel hat.

6. Vorrichtung nach Anspruch 1, 2, 3 oder 4, dadurch gekennzeichnet, dass die erste Gitterstruktur zum Ablenken eines von der Oberfläche nach dem Detektorsystem reflektierten Strahlungsbündels und zum Verformen des abgelenkten Bündels derart ausgelegt ist, dass ein Fokusfehlersignal daraus mit Hilfe des Detektorsystems abgeleitet werden kann.

7. Vorrichtung nach einem oder mehreren der vorangehenden Ansprüche, dadurch gekennzeichnet, dass die Vorrichtung Fokussiermittel (7) zum Fokussieren von Strahlung aus der Strahlungsquellen/Detektoreinheit zu einem Fleck (8) auf der Oberfläche (3) und Abtastmittel zum Steuern der Position des Flecks enthält.

## Revendications

1. Dispositif pour émettre du rayonnement sur une surface (3), ce dispositif étant muni d'une source de rayonnement (5) permettant de délivrer un faisceau de rayonnement (6), d'une trame (17) présentant une première structure de trame pour la formation d'au moins un faisceau partiel dévié (21) à partir du faisceau de rayonnement délivré par la source de rayonnement ou à partir d'un faisceau réfléchi par la surface, d'un système de détection sensible au rayonnement (12) permettant de convertir le rayonnement réfléchi par la surface en signaux électriques, de moyens (17) pour la formation d'un faisceau moniteur (13) à partir du faisceau (6) délivré par la source de rayonnement, et d'un détecteur moniteur (14) pour convertir le faisceau moniteur en un signal électrique pour la commande de la source de rayonnement, caractérisé en ce que les moyens formateurs de faisceau moniteur (17) sont constitués par une deuxième structure de trame dans la trame (17) et en ce que le faisceau moniteur est constitué par du rayonnement réfléchi par la trame.

2. Dispositif selon la revendication 1, caractérisé en ce que la première structure de trame présente une profondeur de rainure de trame qui est pratiquement égale à la moitié de la longueur d'onde du rayonnement et en ce que la deuxième structure de trame est conçue pour une diffraction préférentielle (appelée "blazed" dans la suite du présent mémoire) dans la direction du détecteur moniteur.

3. Dispositif selon la revendication 2, caractérisé en ce que les rainures de trame de la première structure de trame sont pratiquement perpendiculaires aux rainures de trame de la deuxième structure de trame.

4. Dispositif selon la revendication 2 ou 3, caractérisé en ce que la deuxième structure de trame présente une puissance optique.

5. Dispositif selon la revendication 1, 2, 3 ou 4, caractérisé en ce que la première structure de trame est une structure de trame linéaire pour la formation d'un faisceau principal non dévié et deux faisceaux latéraux déviés dans des directions opposées à partir du faisceau de rayonnement délivré par la source et en ce que le système de détection est muni d'un détecteur séparé pour chacun des trois faisceaux réfléchis par la surface.

6. Dispositif selon la revendication 1, 2, 3 ou 4, caractérisé en ce que la première structure de trame est conçue pour dévier un faisceau de rayonnement réfléchi par la surface vers le système de détection et pour déformer le faisceau dévié de façon qu'un signal d'erreur de focalisation en puisse être dérivé à l'aide du système de détection.

7. Dispositif selon l'une des revendications précédentes, caractérisé en ce que le dispositif est muni de moyens de focalisation (7) pour la focalisation du rayonnement délivré par l'unité de détection - source de rayonnement sur un spot (8) sur la surface (3) et de moyens de balayage pour commander la position du spot.
